# EUROPEAN PATENT APPLICATION

(11) **EP 0 703 598 A1**
(43) Date of publication of application: **27.03.1996**
(21) Application number: 95115028.3
(22) Date of filing: 25.09.1995
(51) Int. Cl.: H01J 37/34

(54) **Electrode between sputtering target and workpiece**

(30) Priority: 26.09.1994 US 312505
(71) Applicant: APPLIED MATERIALS, INC., Santa Clara California 95052-8039 (US)
(72) Inventor: Nulman, Jaim, Palo Alto, California 94306 (US)
(74) Representative: Kahler, Kurt, Dipl.-Ing.

(57) **Abstract**

A sputtering chamber (10) for depositing a film on a semiconductor substrate (12) by sputtering a target (14). A collimating electrode (40) between the target (14) and the substrate (12) is connected to a voltage source (50). The voltage can be used to sputter clean the collimator (40), to collimate the flux of target material by accelerating target material ions, or to control the amount of sputtering process gas ions incorporated in the deposited film. A second electrode between the first electrode and the substrate can be connected to a positive voltage to decelerate ions to reduce the risk of damage to the substrate.

## Description

### BACKGROUND OF THE INVENTION

### Field of the Invention

The present invention relates to method and apparatus for sputter deposition onto a semiconductor wafer employing an electrode between the sputtering target and the wafer.

### Background of the Prior Art

Sputtering is a well known method of depositing a thin film layer on a semiconductor substrate. A typical sputtering apparatus includes a vacuum chamber that encloses a target and a substrate support pedestal. The target is typically affixed to the top of the chamber, but is electrically isolated from the chamber walls. A voltage source maintains the target at a negative voltage with respect to the electrically grounded walls of the chamber, to excite a gas, maintained in the chamber at a low pressure, into a plasma. Ions from this plasma sputter the target. As target particles are sputtered from any point on the target, their trajectories have a cosine angular distribution; that is, the density of the sputtered particles ejected from a point on the target along a trajectory having a given angle from perpendicular to the target is proportional to the cosine of such angle. The target particles sputtered from the target generally travel in a straight line path and will tend to deposit on any surface which they contact.

One application of sputtering is the filling of holes and trenches in a dielectric layer on a substrate to form plugs and interconnects. Preferably, the metal film should form a continuous coating of uniform thickness over the entire surface of the dielectric layer, and conformally cover any holes or trenches extending through the dielectric layer. The metal film then may be masked and etched to form isolated metal interconnects on the substrate that extend above the base of the hole or trench by a height that approximately equals the sum of the thickness of the metal film deposited on the dielectric layer and the depth of the hole or trench. To ensure that each interconnect formed on the substrate has the same electrical properties, the holes or trenches must be conformally covered, without non-uniformities or voids. If non-uniformities or voids occur in the material layer deposited in the hole or trench, these non-uniformities or voids can cause defects in the semiconductor being manufactured.

One source of non-uniformities or voids in the material filling the holes and trenches is an inherent feature of sputter deposition, because the target particles travelling at acute angles to the surface of the substrate tend to fill the upper end of the hole or trench, before the target particles travelling in paths substantially perpendicular to the substrate can fill the base of the hole or trench. As a result, the opening of the hole or trench can become sealed with deposition material before the remainder of the volume of the hole or trench is filled. This creates a void within the material otherwise conformally covering the hole or trench.

One method of filling holes or trenches in the dielectric layer without forming voids in the material deposited in the holes or trenches requires using a collimated flux of target material to form the film layer on the substrate. By collimating the flux of target material, the particles of target material that deposit on the substrate will be travelling in paths substantially perpendicular to the upper surface of the substrate. These particles fill the base of the holes or trenches before the particles depositing on the sides of the holes or trenches grow over the hole or trench openings, and thus voids do not form in the target material deposited in the holes or trenches.

One method of forming a collimated stream of target material is to place a plate collimator between the target and the substrate. The plate collimator has a plurality of apertures extending therethrough which are aligned in a generally perpendicular relationship to the substrate. As target particles pass into the area of the plate collimator, only those particles traveling substantially perpendicular to the substrate will pass through the apertures in the plate collimator. Thus, a relatively uniform collimated stream of target material will travel downwardly from the plate collimator to fill the base and sides of the holes. However, a substantial quantity of the particles sputtered from the target will deposit on the upper face of the plate collimator and on the side walls of the plate collimator apertures. It should be appreciated that a substantial fraction of the material sputtered from the target is wasted by being deposited on the surfaces of the plate collimator. Additionally, the plate collimator aperture side walls progressively accumulate a coating of target material which partially blocks the apertures and reduces the aperture width, thereby partially blocking the sputtered target material from passing through the collimator apertures to the substrate. Eventually the particles deposited on the collimator will reduce the amount of particles passing through the collimator apertures to a such a degree that the collimator must be replaced.

A second method of providing a collimated flux of target material uses an ionization device to ionize the target atoms as they are sputtered from the target, and a power supply to maintain a negative voltage on the substrate or substrate support member to electrically attract the ionized target atoms to the substrate. The attraction of the positively charged target material ions to the substrate is such that the ions are electrostaticly collimated into paths substantially perpendicular to the substrate surface. This collimated flux fills the holes in the uppermost layer of the substrate without void formation.

The electrostatic collimation of the flux of target particles solves the problems associated with the deposition of a portion of the target particles on the plate collimator. However, the voltage that must be maintained on the substrate to collimate the target ions into paths which are perpendicular to the substrate can be as great as 1000 volts. This commonly exceeds the maximum voltage that can be maintained on the devices ultimately formed on the substrate without risk of breakdown. Additionally, the energy of the ions impacting the substrate at this voltage may damage the devices formed on the substrate. Thus, the voltage required to electromagnetically collimate the target particle flux may simultaneously create defects in the dielectric layer or in other structures formed on the substrate.

Therefore, there exists a need in the art for a collimating device which will collimate the target material to provide defect free filling of holes and trenches in the uppermost layer or layers of the substrate, but will not need to be periodically cleaned or replaced to maintain peak throughput of target material through the collimating device and will not require the maintenance of high voltages on the substrate.

### SUMMARY OF THE INVENTION

According to the present invention, a sputtering chamber for depositing a film on a semiconductor substrate employs a collimating electrode which is connected to an electrical power supply and which is positioned between the substrate and the sputtering target. The invention includes a number of different inventive aspects or variations on the basic feature of a collimating electrode to which a voltage is applied.

This object is solved by the features described in claims 1, 3, 11, 17, 19, 21, 24, 27, and 30, respectively. Particular embodiments of the invention are set out in the dependent claims.

In a first aspect of the invention, the collimating electrode is a perforated plate collimator of the type conventionally used to achieve collimation mechanically due to the depth of the perforations or apertures in the collimator plate. By applying a negative voltage to the plate collimator during sputtering, the surfaces of the plate collimator will be sputter cleaned as substrates are processed in the chamber. The voltage may be applied to the plate collimator by a D.C. or A.C. (low frequency or R.F.) source. In the case of an A.C. power supply, the sputter cleaning of the collimator will occur during the periods the alternating voltage on the collimator is negative. The sputter cleaning reduces or eliminates the accumulation of particles which otherwise would block the collimator apertures in conventional designs, thereby reducing or eliminating the need to periodically replace or clean the collimator.

In a second aspect of the invention, the collimating electrode is an open (i.e., porous) grid electrode connected to an electrical power supply. Additionally, an ionizing power source is employed to apply electrical power to a region between the sputtering target and the grid electrode so as to ionize at least a portion of the atoms sputtered from the target. When the voltage applied to the grid is negative with respect to the chamber walls, the ionized atoms of target material are accelerated, toward the grid. Because the grid is porous, most of the ions accelerated toward the grid pass through the grid and deposit on the substrate. The acceleration of the target material ions toward the substrate causes the trajectories of the ions to be more perpendicular to the substrate, thereby electrostatically collimating the target material deposited on the substrate.

The voltage may be applied to the grid electrode by a D.C. or A.C. (low frequency or R.F.) power supply. In the case of an A.C. power supply, the accleration of ionized target material toward the substrate will occur during the periods the alternating voltage on the collimator is negative.

By applying the high voltage necessary to attract and electrostatically collimate the ionized target material to the grid rather than to the substrate, the high voltages placed on the substrate in prior art ionized sputtering systems can be eliminated or significantly reduced, thereby eliminating or significantly reducing device damage caused by high voltages on the substrate.

Additionally, the grid may be used to control the extent to which ions of the process gas (e.g., argon) used to sputter the target are incorporated into the film deposited on the substrate. Increasing the negative voltage on the grid increases the acceleration of process gas ions toward the substrate, thereby increasing the concentration of process gas species in the film of target material deposited on the substrate. The electrical, optical and chemical properties of the deposited film can be advantageously controlled by including a controlled amount of process gas species in the film.

Either the plate collimator electrode invention or the grid electrode invention can be further improved by adding a second electrode between the first electrode and the substrate. Preferably, the second electrode is an open grid to which a positive voltage is applied. The positive voltage reduces the energy of the ions accelerated toward the substrate by the first electrode, thereby reducing the possibility that the ions bombarding the substrate will damage the semiconductor devices on the substrate.

### BRIEF DESCRIPTION OF THE DRAWINGS

Figure 1 is a perspective view, partially in section, of a sputtering chamber including one embodiment of the collimating element of the present invention;
Figure 2 is a perspective view, partially in section, of a sputtering chamber including an alternative embodiment of the collimating element of the present invention; and
Figure 3 is a perspective view, partially in section, of a sputtering chamber including a further alternative embodiment of the collimating element of the present invention.

### DETAILED DESCRIPTION OF THE PREFERRED EMBODIMENTS

### CONVENTIONAL SPUTTERING APPARATUS

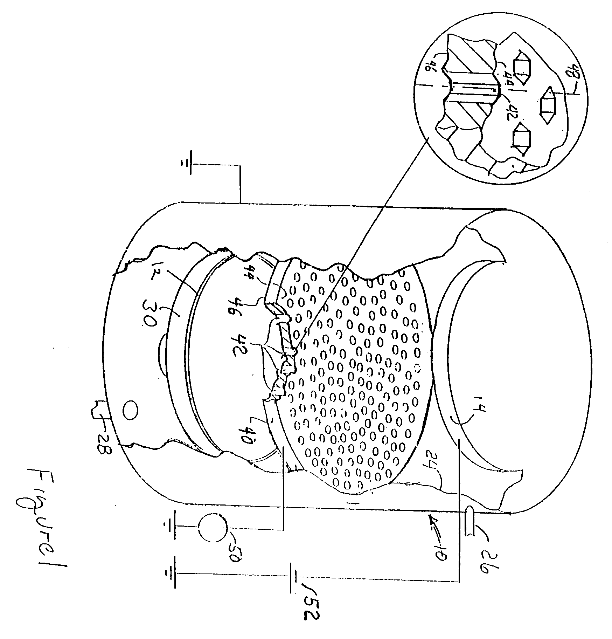

Referring to Figure 1, the sputtering apparatus of the preferred embodiment of the invention includes a conventional vacuum chamber 10 having a conventional target 14 suspended therein. One suitable sputtering chamber and target is disclosed in United States Patent Number 5,242,566, *Parker*, the disclosure of which is fully incorporated herein by reference. The vacuum chamber 10 conventionally includes a chamber enclosure wall 24, having at least one gas inlet 26 and an exhaust outlet 28 connected to an exhaust pump (not shown). A substrate support pedestal 30 is disposed at the lower end of the chamber 10, and the target 14 is received at the upper end of the chamber 10. The target 14 is electrically isolated from the enclosure wall 24, and the enclosure wall 24 is preferably electrically grounded, so that a voltage may be maintained on the target 14 with respect to the grounded enclosure wall 24.

During the deposition process a sputtering process gas, typically a non-reactive species such as argon, is supplied into the vacuum chamber 10 through the gas inlet 26 at a selected flow rate regulated by a mass flow controller valve (not shown). The pressure within the chamber 10 is regulated by controlling the rate at which the gases are pumped out of the chamber through the exhaust outlet 28.

A D.C. power supply 52 applies a negative voltage on the target 14 with respect to the electrically grounded enclosure wall 24 so as to excite the gas into a plasma state. Ions from the plasma bombard the target 14 and sputter particles of target material from the target 14.

A substrate 12 is placed on the pedestal 30 in a spaced, parallel, relationship to the target 14. The target 14 is sputtered to provide a flux of target material to form a deposition layer on the substrate 12. The deposition layer may, if desired, be formed over one or more dielectric, metal or other layers previously formed on the substrate 12, and may fill or conformally cover holes or trenches in a dielectric or other layer to form a plug or interconnect on the substrate 12.

Additionally, the chamber 10 is preferably configured as a conventional magnetron sputtering apparatus, wherein a magnet (not shown) is placed above the target 14 to increase the ion concentration adjacent the target 14, and particularly in an annular region intermediate the center and the perimeter of the target 14. One such apparatus is disclosed in United States Patent Number 5,242,566, *Parker*, the disclosure of which is fully incorporated herein by reference.

### THE PLATE COLLIMATOR EMBODIMENT

Referring still to Figure 1, one embodiment of the collimating element of the present invention is shown, wherein the collimating element includes a conventional plate collimator 40 supported within the chamber 10 between the substrate support pedestal 30 and the target 14. The plate collimator 40 is a generally planar member having an upper surface 44, a lower surface 46 and a plurality of apertures 42 extending through the plate between the top surface 44 and bottom surface 46. Each aperture 42 preferably is a hexagonal opening, preferably having a longitudinal axis 48 perpendicular to the substrate 12.

The length and diameter of each aperture 42 are chosen according to conventional principles for designing a plate collimator. Specifically, the ratio of length to diameter of each aperture 42 is large enough to ensure that any target material travelling in a direction substantially oblique to the substrate (that is, travelling in a trajectory which deviates from a perpendicular to the substrate by more than a predetermined angle) will deposit on the sides of the apertures 42, so that the collimator plate blocks such oblique trajectory material from being deposited on the substrate. Conversely, the ratio of length to diameter of each aperture 42 is small enough to permit most of the target material travelling substantially perpendicular to the substrate to pass through the collimator 40 and deposit on the substrate 12.

The plate collimator 40 is supported within the chamber 42 in electrical isolation from the previously described chamber components, and a power supply 50 applies a voltage between the collimator 40 and the electrically grounded chamber wall 24. The power supply 50 may be a D.C. power supply or an A.C. (R.F. or low frequency) power supply.

During the deposition of a film on the semiconductor substrate 12 by sputtering of the target 14, a portion of the sputtered atoms of target material deposit on the plate collimator 40, including the surface of the apertures 42. In the prior art, the plate collimator 40 requires regular cleaning or replacement when target material begins to obstruct the apertures 42. In contrast, my invention cleans target material off the plate collimator 40 almost as soon as it is deposited there. This is accomplished by applying a negative voltage to the plate collimator 40 with respect to the grounded enclosure wall 24, and by positioning the plate collimator 40 within the plasma region, so that the surfaces of the plate collimator 40, including the walls of the apertures 42, are sputter cleaned by ions of sputtering process gas (typically argon). Thus, the need to periodically replace or clean the plate collimator because of the build up of target material thereon is reduced or eliminated.

The electrical power supply 50 can apply a negative D.C. voltage to the plate collimator 40, thereby effecting continuous sputter cleaning of the collimator 40 whenever a plasma is present in the chamber. Alternatively, the power supply 50 can apply an A.C. voltage (R.F. or low frequency A.C.) to the plate collimator 40, thereby sputter cleaning the plate collimator 40 in pulses during negative portions of the alternating voltage waveform, that is, during periods when the collimator 40 is at a sufficiently negative voltage with respect to the enclosure walls 24 and the plasma to accelerate the plasma ions to bombard the plate collimator 40.

An A.C. power supply 50 preferably is connected to the collimator electrode 40 through a capacitor. Electrons from the plasma will build up a D.C. voltage across the capacitor so that the collimator becomes negatively biased with respect to the electrically grounded chamber walls. The negative bias voltage increases the rate of sputter cleaning of the collimator.

The capacitor may be a series-connected output coupling capacitor within the A.C. power supply itself or within an impedance matching network connected between the power supply and the collimator.

Alternatively, power supply 50 can be implemented as a D.C. power supply and an A.C. power supply connected in series, permitting independent control of the A.C. and D.C. voltages applied to the collimator.

When an A.C. voltage is applied to the plate collimator 40, cleaning (i.e., sputter etching) of the plate collimator 40 occurs when the collimator is at a negative voltage, and deposition of target material on the collimator occurs when the collimator is at a positive voltage. By adjusting the ratio of A.C. voltage to negative D.C. bias, an ideal one-to-one ratio of etch rate to deposition rate can be achieved. A lower ratio will accelerate the rate at which the collimator apertures become occluded, and a higher ratio can cause the collimator material to be etched and contaminate the film being deposited on the substrate 12. To avoid the latter problem, the plate collimator 40 may be composed of the same material as the target 14, so that material sputtered from the plate collimator 40 does not contaminate the substrate 12. Alternatively, a coating of target material may be applied to the plate collimator 40 with a thickness sufficient to ensure that the base metal of the plate collimator 40 is not exposed during processing.

The coating of target material can be deposited on the plate collimator 40 before it is placed in the chamber 10 using any conventional deposition process. Alternatively, before the collimator is first used for processing semiconductor substrates 12 in the chamber, a layer of target material can be sputtered onto the plate collimator 40 in the chamber 10. The latter can be accomplished by connecting the collimator to electrical ground so that it functions as an anode relative to the negatively biased target (cathode) 14. For subsequent processing of substrates 12 in the chamber 10, the collimator should be disconnected from ground and connected to the electrical power supply 50 as described above.

### ADVANTAGES OF THE PLATE COLLIMATOR EMBODIMENT

By sputter cleaning the plate collimator 40 as substrates 12 are processed in the chamber 10, it is contemplated that the plate collimator 40 may be used indefinitely without the need for replacement or cleaning. Thus, the advantageous directionality of the target material flux is provided by the plate collimator 40, but the cleaning or replacement regimen formerly necessitated by target material build up on conventional plate collimator 40 surfaces is eliminated.

The voltage on the plate collimator 40 also may be adjusted to control the amount of sputter process gas atoms (typically argon) incorporated into the film deposited on the substrate 12, as will be described in more detail below.

### THE GRID ELECTRODE EMBODIMENT

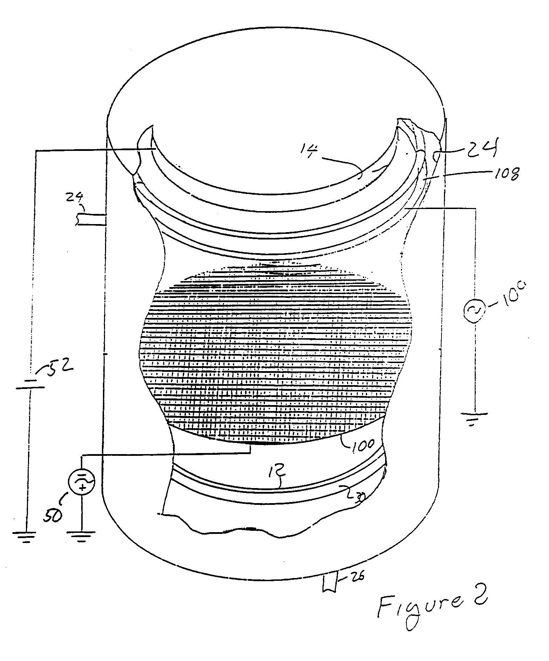

Referring now to Figure 2, an alternative embodiment of the invention is shown wherein the collimating element is a generally planar grid 100 disposed parallel to the substrate 12 and located immediately adjacent the upper surface of the substrate 12 on which a film is to be deposited by sputtering of the target 14. The grid 100 is mounted to the enclosure wall 24 with an electrically insulating member (not shown) and is preferably configured as an electrically conductive mesh or screen that has minimal surface area and minimal thickness, so as to not significantly restrict the passage of sputtered target material therethrough.

Additionally, the chamber 10 includes an ionizing power source, such as a coil 108 connected to an R.F. power supply 109, which supplies a high energy field to a region between the grid 100 and the target 14 to ionize the target material atoms as they are sputtered from the target 14. One suitable ionizing power source and chamber configuration for providing a source of ionized target atoms is described in United States Patent 5,178,739 to Barnes et al.

The grid 100 is maintained at a negative voltage, preferably on the order of about 200 to 1000 volts, with respect to the grounded chamber walls 24. The negative voltage accelerates ions of material sputtered off the target toward the grid 100, and hence perpendicular to the substrate 12, thereby electrostatically collimating the flux of target ions depositing on the substrate 12. In other words, by placing the planar surface of the grid 100 parallel and adjacent to the upper surface of the substrate, the ions adjacent and above the grid 100 will be accelerated in paths perpendicular to both the grid 100 and the substrate 12 and in the direction of the substrate 12. Because the grid 100 is an open or porous array of conductors with minimal surface area, most of the ions pass through the grid 100 and deposit on the substrate 12 while still travelling in paths perpendicular to the upper surface of the substrate.

The grid 100 may be D.C. biased or A.C. (low frequency or R.F.) biased by a power supply 50. When the grid is negatively D.C.-biased, target ions are continuously accelerated toward the grid 100 and thus the substrate 12. When the grid 100 is A.C. biased, target ions will be accelerated toward the grid 100 and the substrate 12 whenever the grid 100 is at a negative voltage. A D.C. power supply (not shown) may be connected in series with an A.C. power supply 50 to impress a negative D.C. voltage on the grid 100 in addition to the low frequency A.C. voltage. Alternatively, the A.C. power supply 50 can be a capacitively coupled to the grid, as explained in the preceding description of the plate collimator embodiment, to impose a negative bias voltage on the grid 100 due to an accumulation of electrons from the plasma. The superimposed negative bias voltage and A.C. voltage causes the acceleration of the ionized target atoms toward the substrate to be pulsed at the frequency of the A.C. voltage.

### ADVANTAGES OF THE SINGLE GRID ELECTRODE EMBODIMENT

When used in combination with an ionizing power source, such as coil 108 and power supply 109 as described above, for ionizing the material sputtered off the target, the grid 100 accelerates the target material ions in the direction of the substrate 12 to provide an electrostatically collimated stream or flux of target material ions travelling substantially perpendicular to the substrate. Thus, a collimated stream or flux of target material is provided at the surface of the substrate 12, without the need to use a plate collimator or other mechanical collimating device. Mechanical collimators necessarily waste target material because they operate by mechanically blocking sputtered target material whose trajectory is excessively oblique. Electrostatic collimators do not block the sputtered material, but advantageously alter their trajectories to be more perpendicular to the substrate.

Prior electrostatic collimator designs collimated ionized target material by negatively biasing the semiconductor substrate rather than biasing a separate electrode as in my invention. However, applying a high voltage to the substrate can damage the semiconductor devices formed thereon. By applying a negative voltage to the grid 100, my invention can achieve the same collimation performance as prior designs while greatly reducing or eliminating the voltage that must be applied to the semiconductor substrate, thereby reducing the risk that such voltage will damage semiconductor devices on the substrate.

The grid 100 also may be self cleaning. In operation, sputtering gas ions will collide with the grid 100 and sputter any target material that may have deposited on the grid 100 off the grid 100. By applying a more negative voltage to the grid 100, the rate at which sputtering gas ions collide with the grid 100 will be increased, thereby increasing the cleaning rate of the grid surfaces. The deposition rate and sputter cleaning rate on the grid 100 may be balanced by adjusting the negative bias voltage on the grid 100.

The voltage on the grid 100 also may be adjusted to control the amount of sputter process gas atoms (typically argon) incorporated into the film deposited on the substrate 12, as will be described in more detail below.

### SECOND ELECTRODE

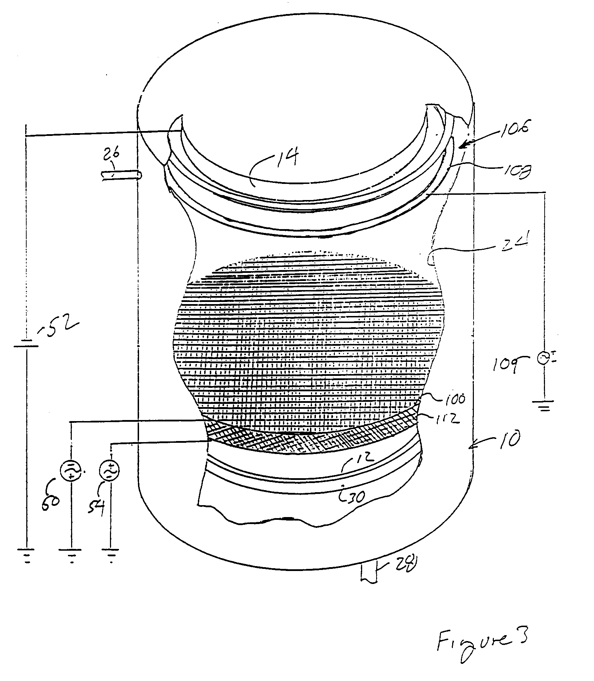

Figure 3 illustrates a further improvement which can be applied to either the plate collimator apparatus of Figure 1 or the grid collimator apparatus of Figure 2. The improvement is a second electrode 112 positioned between the first electrode 40 or 100 and the substrate 12, preferably much closer to the substrate. The structure of the second electrode 112 can be the same as described for the collimator electrode 100.

The second electrode 112 is maintained either at a positive voltage with respect to ground, or else at a less negative voltage than the first electrode. Consequently, the second electrode decelerates the ions which were accelerated toward the substrate by the first electrode 40 or 100, thereby reducing the risk that high energy ion bombardment will damage semiconductor devices on the substrate.

If positively biased with respect to ground, the second grid 112 also will attract electrons from the area adjacent the substrate surface, and thereby prevent high energy electron impacts on the substrate 12.

The voltage applied to the second grid 112 may be supplied by a D.C.power supply 54, or by an A.C. power supply (not shown) in series with the D.C. power supply 54.

### CONTROLLING INCORPORATION OF PROCESS GAS INTO DEPOSITED FILM

The voltage applied to the collimator electrode, whether it is a plate collimator 40 or a grid collimator 100, can be adjusted to control the rate at which argon ions, or ions of other species in the plasma, are incorporated in the film deposited on the substrate. A negative voltage on the collimator electrode 40 or 100 with respect to the grounded enclosure wall will attract ionized species from the sputtering process gas. By adjusting the voltage applied to the plate collimator 40 to be more (or less) negative, the quantity of sputtering gas ions passing through the grid and depositing on the substrate will increase (or decrease), thereby increasing (or decreasing) the proportion of argon ions, or other species in the sputtering process gas, incorporated in the film of target material deposited on the semiconductor substrate. The electrical, optical and chemical properties of the deposited film can be advantageously controlled by including a controlled amount of process gas species in the film.

If the sputtering chamber has no power source 108,109 for ionizing the sputtered target material, the sputtered material will have no electrical charge. Consequently, adjusting the voltage on the collimator electrode 40 or 100 will control the deposition rate of the process gas species without affecting the target material deposition rate. Therefore, the collimator electrode provides a method of controlling the proportion of process gas species incorporated in the film deposited on the substrate.

Conversely, if the sputtering chamber does include a power source 108,109 for ionizing the material sputtered off the target, the power output level of power supply 109 can be adjusted to control what fraction of the sputtered target material is ionized.

The proportion of sputtering process gas species incorporated in the film deposited on the substrate also can be increased (decreased) by increasing (decreasing) the partical pressure of the desired gas species in the chamber.

## Claims

1. Apparatus for deposition onto a semiconductor substrate of a collimated flux of material sputtered from a target, comprising:
a sputtering chamber having an electrically grounded wall;
a sputtering target within the chamber;
a gas source for supplying a process gas into the chamber;
a plasma source for exciting the gas into a plasma state in a region adjacent the target to promote sputtering of material from the target;
a support member for holding the substrate within the chamber;
a collimator electrode between the target and the substrate support; and
a first voltage source connected to supply a first voltage between the collimator electrode and the grounded chamber wall;
whereby the first voltage controls the amount of process gas atoms which are incorporated in the material deposited on the substrate.

2. Apparatus according to claim 1, further comprising:
a second electrode between the collimator electrode and the substrate support, and
a second voltage source connected to supply a voltage to the second electrode which is positive relative to the grounded chamber wall,
whereby the positive voltage on the second electrode decelerates ions traveling from the direction of the collimator toward the substrate, reducing the risk of high energy ions damaging the substrate.

3. Apparatus for deposition onto a semiconductor substrate of a collimated flux of material sputtered from a target, comprising:
a sputtering chamber having a wall connected to an electrical ground;
a sputtering target within the chamber;
a gas source for supplying a process gas into the chamber;
a plasma source for exciting the gas into a plasma state in a region adjacent the target to promote sputtering of material from the target;
a support member for holding the substrate within the chamber;
a perforated collimator plate between the target and the substrate support, the collimator plate being perforated with one or more apertures, each aperture having a length and width such that the ratio of length to width is great enough to obstruct the passage through the collimator of target material having a trajectory deviating by more than a predetermined angle from a perpendicular to the substrate; and
a first voltage source connected to supply a first voltage to the collimator plate;
whereby the first voltage controls the proportion of process gas atoms which are incorporated in the material deposited on the substrate.

4. Apparatus according to claim 3, wherein the first voltage is negative with respect to said electrical ground during some periods of time, whereby ions in the plasma are attracted to the collimator plate to sputter clean the collimator plate.

5. Apparatus according to claim 4, further comprising:
a second electrode between the collimator electrode and the substrate support, and
a second voltage source connected to supply a voltage to the second electrode which is positive relative to the grounded chamber wall,
whereby the positive voltage on the second electrode decelerates ions traveling from the direction of the collimator toward the substrate, reducing the risk of high energy ions damaging the substrate.

6. Apparatus according to claim 4, wherein the collimator has at least an outer portion composed of the same material as the target.

7. Apparatus according to claim 4, wherein the first voltage source supplies a negative D.C. voltage.

8. Apparatus according to claim 4, wherein the first voltage source supplies an A.C. voltage having a periodic waveform which is negative during a portion of its cycle.

9. Apparatus according to claim 4, wherein the first voltage source supplies an A.C. voltage superimposed with a negative D.C. offset voltage.

10. Apparatus according to claim 4, wherein the first voltage source includes:
an A.C. voltage supply, and
a capacitor connected between the A.C. voltage supply and the collimator,
whereby a D.C. voltage develops across the capacitor to impose a negative D.C. bias on the collimator.

11. Apparatus for deposition onto a semiconductor substrate of a collimated flux of material sputtered from a target, comprising:
a sputtering chamber having a wall connected to an electrical ground;
a sputtering target within the chamber;
a gas source for supplying a process gas into the chamber;
a plasma source for exciting the gas into a plasma state in a region adjacent the target to promote sputtering of material from the target;
a support member for holding the substrate within the chamber;
a porous grid electrode between the target and the substrate support;
an ionizing power source for supplying energy to ionize at least a portion of the sputtered target material in a region between the target and the grid; and
a first voltage source connected to supply to the electrode a first voltage which is negative with respect to said electrical ground at least a portion of the time;
whereby, during periods when the first voltage is negative, ionized target material is acclerated toward the grid, thereby collimating the flux of target material being deposited on the substrate.

12. Apparatus according to claim 11, further comprising:
a second electrode between the collimator electrode and the substrate support, and
a second voltage source connected to supply a voltage to the second electrode which is positive relative to the grounded chamber wall,
whereby the positive voltage on the second electrode decelerates ions traveling from the direction of the collimator toward the substrate, reducing the risk of high energy ions damaging the substrate.

13. Apparatus according to claim 11, wherein the first voltage source supplies a negative D.C. voltage.

14. Apparatus according to claim 11, wherein the first voltage source supplies an A.C. voltage having a periodic waveform which is negative during a portion of its cycle.

15. Apparatus according to claim 11, wherein the first voltage source supplies an A.C. voltage superimposed with a negative D.C. offset voltage.

16. Apparatus according to claim 11, wherein the first voltage source includes:
an A.C. voltage supply, and
a capacitor connected between the A.C. voltage supply and the grid electrode,
whereby a D.C. voltage develops across the capacitor to impose a negative D.C. bias on the grid electrode.

17. A method of controlling the incorporation of a sputtering gas in a film layer deposited on a substrate, comprising:
providing a grounded enclosure having at least a sputtering target and a substrate support therein;
providing a sputtering gas into the enclosure and exiting the gas into a plasma;
sputtering the target with the plasma to provide a flux of target material to form a film layer on the substrate;
placing a a porous electrode intermediate the substrate and the target;
applying a negative voltage to the porous electrode to attract ions of the sputtering gas in the direction of, and through, the porous electrode to deposit on the substrate; and
varying the magnitude of the negative voltage applied to the porous electrode and thereby changing the quantity of sputtering gas incorporated in the film deposited on the substrate relative to the quantity of target material deposited on the substrate.

18. The method of claim 17, including the further step of:
varying the partial pressure of the sputtering gas in the enclosure and thereby changing the quantity of sputtering gas incorporated in the film deposited on the substrate relative to the quantity of target material deposited on the substrate.

19. A method of controlling the incorporation of a sputtering gas in a film layer deposited on a subst:rate, comprising:
providing a grounded enclosure having at least a sputtering target and a substrate support therein;
providing a sputtering gas into the enclosure and exiting the gas into a plasma;
sputtering the target with the plasma to provide a flux of target material to form a film layer on the substrate;
placing a porous electrode intermediate the substrate and the target;
applying a negative voltage to the porous electrode to attract ions of the sputtering gas in the direction of, and through, the porous electrode to deposit on the substrate; and
varying the partial pressure of the sputtering gas in the enclosure and thereby changing the quantity of sputtering gas incorporated in the film deposited on the substrate relative to the quantity of target material deposited on the substrate.

20. The method of claim 19, including the further step of:
varying the magnitude of the negative voltage applied to the porous electrode and thereby changing the quantity of sputtering gas incorporated in the film deposited on the substrate relative to the quantity of target material deposited on the substrate.

21. A method of preparing a plate collimator for use in a sputtering chamber wherein the plate collimator may be sputter cleaned during use, comprising:
providing a sputtering chamber having an enclosure and a target therein;
locating a plate collimator adjacent the target; and
sputtering the target while connecting the collimator to electrical ground, so as to deposit a layer of target material on the collimator.

22. The method of claim 21, further including the steps of:
positioning a substrate support member in the sputtering chamber such that the collimator is disposed between the substrate support member and the target;
sputtering the target to provide a flux of target material for deposition on the substrate;
passing the flux of target material through the collimator and thereby collimating the flux of target material reaching the substrate; and
maintaining a negative voltage on the collimator to sputter clean the collimator.

23. The method of claim 22, including the further step of maintaining the negative voltage on the collimator during at least a portion of the duration of the step of sputtering the target.

24. A method of depositing onto a semiconductor substrate a collimated flux of material sputtered from a target, comprising:
supporting a semiconductor wafer within a sputtering chamber having a sputtering target and an electrically grounded wall;
supplying a process gas into the chamber;
exciting the gas into a plasma state in a region adjacent the target to sputter material from the target;
providing a collimator electrode between the target and the substrate support; and
supplying a first voltage between the collimator electrode and the grounded chamber wall;
whereby the first voltage controls the proportion of process gas atoms which are incorporated in the material deposited on the substrate.

25. A method according to claim 24, further comprising the step of adjusting the first voltage so as to deposit onto the substrate a film of target material which contains a desired proportion of process gas atoms.

26. A method according to claim 24, further comprising:
providing a second electrode between the collimator electrode and the substrate, and
supplying to the second electrode a voltage which is positive relative to the grounded chamber wall,
whereby the positive voltage on the second electrode decelerates ions traveling from the direction of the collimator toward the substrate, reducing the risk of high energy ions damaging the substrate.

27. A method for depositing onto a semiconductor substrate a collimated flux of material sputtered from a target, comprising:
supporting a semiconductor wafer within a sputtering chamber having a sputtering target and an electrically grounded wall;
supplying a process gas into the chamber;
exciting the gas into a plasma state in a region adjacent the target to sputter material from the target;
providing a perforated collimator plate between the target and the substrate support, the collimator plate being perforated with one or more apertures, each aperture having a length and width such that the ratio of length to width is great enough to obstruct the passage through the collimator of target material having a trajectory deviating by more than a predetermined angle from a perpendicular to the substrate; and
supplying a first voltage between the collimator plate and the grounded chamber wall;
whereby the first voltage controls the proportion of process gas atoms which are incorporated in the material deposited on the substrate.

28. A method according to claim 27, wherein the first voltage is negative with respect to said electrical ground during some periods of time, whereby ions in the plasma are attracted to the collimator plate to sputter clean the collimator plate.

29. A method according to claim 28, further comprising:
providing a second electrode between the collimator electrode and the substrate, and
supplying to the second electrode a voltage which is positive relative to the grounded chamber wall,
whereby the positive voltage on the second electrode decelerates ions traveling from the direction of the collimator toward the substrate, reducing the risk of high energy ions damaging the substrate.

30. A method of depositing onto a semiconductor substrate a collimated flux of material sputtered from a target, comprising:
supporting a semiconductor wafer within a sputtering chamber having a sputtering target and an electrically grounded wall;
supplying a process gas into the chamber;
exciting the gas into a plasma state in a region adjacent the target to sputter material from the target;
providing a porous grid electrode between the target and the substrate support; and
supplying energy to ionize at least a portion of the sputtered target material in a region between the target and the grid; and
supplying a first voltage between the collimator electrode and the grounded chamber wall which is negative with respect to said electrical ground at least a portion of the time;
whereby, during periods when the first voltage is negative, ionized target material is acclerated toward the grid, thereby collimating the flux of target material being deposited on the substrate.

31. A method according to claim 30, further comprising:
providing a second electrode between the collimator electrode and the substrate, and
supplying to the second electrode a voltage which is positive relative to the grounded chamber wall,
whereby the positive voltage on the second electrode decelerates ions traveling from the direction of the collimator toward the substrate, reducing the risk of high energy ions damaging the substrate.
